(19) Europäisches Patentamt
European Patent Office
Office européen des brevets

(11) **EP 1 863 084 B1**

(12) **EUROPEAN PATENT SPECIFICATION**

(45) Date of publication and mention
of the grant of the patent:
**05.01.2011 Bulletin 2011/01**

(51) Int Cl.:
***H01L 23/02*** *(2006.01)*

(21) Application number: **06712766.2**

(22) Date of filing: **01.02.2006**

(86) International application number:
**PCT/JP2006/301623**

(87) International publication number:
**WO 2006/112105 (26.10.2006 Gazette 2006/43)**

(54) **METHOD FOR MANUFACTURE OF HERMETIC SEAL COVER**

VERFAHREN ZUR HERSTELLUNG EINER HERMETISCHEN DICHTABDECKUNG

PROCEDE POUR FABRIQUER UN COUVERCLE DE FERMETURE HERMETIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.04.2005 JP 2005110996**

(43) Date of publication of application:
**05.12.2007 Bulletin 2007/49**

(73) Proprietor: **TANAKA KIKINZOKU KOGYO KABUSHIKI KAISHA**
**Chiyoda-ku, Tokyo 100-6422 (JP)**

(72) Inventors:
• **MIYAZAKI, Kenichi,**
**c/o TANAKA KIKINZOKU KOGYO K.K.**
**Hiratsuka-shi,**
**Kanagawa 254-0076 (JP)**
• **MANO, Shinsuke,c/o TANAKA KIKINZOKU KOGYO K.K.**
**Hiratsuka-shi,**
**Kanagawa 254-0076 (JP)**

(74) Representative: **Moy, David et al**
**Appleyard Lees**
**15 Clare Road**
**Halifax HX1 2HY (GB)**

(56) References cited:
| | |
|---|---|
| JP-A- 2001 148 438 | JP-A- 2002 033 408 |
| JP-A- 2002 033 408 | JP-A- 2004 186 428 |
| US-A- 4 640 438 | US-A- 5 639 014 |
| US-A1- 2004 104 460 | US-A1- 2005 062 067 |

## Description

### Technical Field

The present invention relates to a method of manufacturing of hermetic seal cover with a brazing material fused thereto, which is used in hermetic sealing of various electronic component packages. More specifically, the present invention relates to a method of manufacturing of a hermetic seal cover in which the shape of a brazing material after being mounted is controlled and spread of the brazing material during sealing is stable.

### Background Art

Semiconductor elements such as SAW filters and quartz resonators which are used in various electronic devices such as cellular phones are used in the state sealed in ceramics containers (packages) which prevent them from being oxidized and deteriorated by humidity and oxygen in the air. The semiconductor packages are each constituted of a container body (base) having an opening and a seal cover to be a lid, and a hermetically sealing process of the semiconductor package is carried out by mounting a semiconductor element in the base, putting the seal cover on it, and thereafter, joining the base and the seal cover.

There are various methods for joining the base and the seal cover, and a brazing method for joining them by a brazing material is generally used. The seal cover used in a brazing method has a brazing material fused on its joint surface, and on the occasion of hermetic sealing, the seal cover is put on the base, and they are heated in an electric furnace or the like to fuse and solidify the brazing material to be a package.

As a composing material of a seal cover main body, Koval (Fe-Ni-Co alloy), and a 42 alloy (Fe-Ni alloy) are generally used. As the brazing material, Au-Sn brazing material is used for the reason of excellence in reliability and corrosion resistance, and a brazing material of Au80wt%-Sn20wt% which is an eutectic composition is especially used in general. The seal cover is generally produced by fusing an Au-Sn brazing material formed in a window frame shape in consideration of the shape of the base by punching or the like to the seal cover main body.

Patent Document 1: Japanese Patent Application Laid-Open No. 2003-224223

As the defect which is feared in a semiconductor package produced by sealing by a brazing method, poor joint of the base and the seal cover is considered first, and in addition to this, inflow of the brazing material, which fuses at the time of package sealing, to the base is cited. Such inflow of the brazing material affects the semiconductor element, and especially in a quartz resonator, a serious damage such as a variation in frequency is given to its performance.

The problem of influx of the brazing material is considered to depend on the amount of the brazing material fused to the seal cover and stability of the flow of the brazing material. Specifically, when the amount of the brazing material is large, and the flow of it is unstable, the fused brazing material flows on the seal cover surface and enters the base irregularly.

In such a case, it is considered to reduce the amount of the brazing material and prevent the excess brazing material from entering the base. However, this causes an insufficient brazing material in a gap between the base and the seal cover, and the gap cannot be completely sealed, so that the problem of occurrence of poor joint remains.

Thus, an object of the present invention is to provide, in a seal cover for package sealing to which a brazing material is fused, a seal cover in which inflow of the brazing material to a base which becomes a cause of a defect of a package does not occur. In this case, it is the precondition that poor joint of the base and the seal cover does not occur.

Further methods of manufacturing of seal covers are described in US4640438 and US5639014

### Disclosure of the Invention

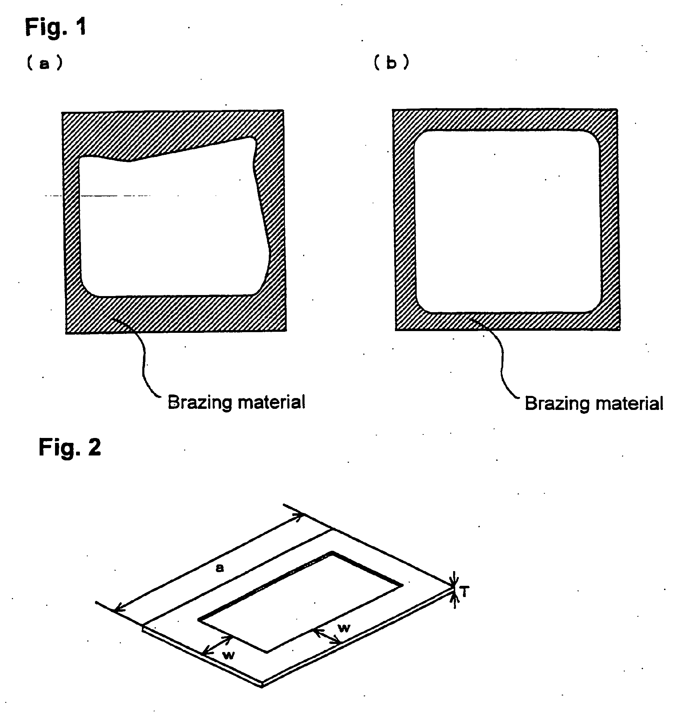

The present inventors made a study to solve the above described problem, and decided to control the shape of a brazing material fused to the seal cover main body. In the conventional seal cover, even when the brazing material is formed into a window frame shape before being fused, it becomes an indefinite shape as shown in Fig. 1a after being fused. When the brazing material shape becomes indefinite, the flow of the brazing material when joined to the base becomes irregular in accordance with regions, and the possibility of flowing into the base becomes high. Thus, it is conceivable that irregular flow of the brazing material can be suppressed by bringing the brazing material shape after being fused into a state substantially equal to the shape before being fused (see Fig. 1(b)).

In order to control the shape of the brazing material after being fused (after being solidified), it is necessary to control the flow of the brazing material in the surface of the cover main body when the brazing material is fused. Controlling the brazing material flow in the cover main body surface can suppress irregular flow of the brazing material at the time of being joined to the base, and inflow of the brazing material to the base can be prevented.

The present inventors made a study on control of the flow of the brazing material on the cover main body surface with the above as a background. The present inventors made a study on the factor which influences stability of the flow of an Au-Sn brazing material, and paid attention to the surface roughness of the cover main body surface. The present inventors found that stability of the flow of the brazing material becomes favorable in the cover main body having predetermined surface roughness, and reached the present invention.

In the present invention, the reason of making the surface roughness of the surface of the seal cover main body to which the brazing material is fused 0.005 to 0.25 $\mu$m is that with the surface roughness exceeding 0.25 $\mu$m, flow (spread) of the brazing material becomes irregular at the time of being fused, and the shape of the brazing material after being fused becomes indefinite from the study of the present inventors. The reason of the lower limit of 0.005 $\mu$m is that it is difficult to work the surface of the cover main body to the surface roughness less than this value, and the surface roughness of less than this value is not suitable for mass production. The reason of adopting the surface roughness defined by JIS B0601 is to clarify its standard. An especially preferable range of the surface roughness is 0.005 to 0.1 $\mu$m.

In the present invention as claimed in claim 1 it is suitable if the surface roughness of the surface to which the brazing material is fused is in the above described range. Accordingly, when the brazing material is directly fused to the seal cover main body, it is suitable if the surface roughness of the seal cover main body is in the above described range. Here, as the material of the seal cover main body in the present invention, the material similar to that of the conventional seal cover is applicable, and Koval or a 42 alloy is preferable.

In an ordinary seal cover, one made by applying Ni plating and Au plating to the base material made of Koval or the like is used as the seal cover main body for the purpose of securing corrosion resistance of the seal cover and securing wettability when the Au-Sn brazing material is fused, and the brazing material is fused to the seal cover main body to form a seal cover. In the seal cover having such plating, the Au-plated surface is the surface to which the brazing material is fused, and its surface roughness is required to be within the above described range.

Here, the present inventors have found that when Au plating is applied to the seal cover main body, there is correlation between the thickness of it and stability of the brazing material at the time of being fused. According to the present inventors, by applying plating so that the Au plating thickness is within the range of 0.003 to 0.05 $\mu$m as well as by making the surface roughness within the proper range, flow of the brazing material becomes stable, and the brazing material after being fused can be in a preferable shape. When the Au plating thickness is less than 0.003 $\mu$m, wettability becomes extremely bad, and manufacture yield of the seal cover reduces. It is especially preferable to make the thickness of the Au plating layer 0.005 to 0.025 m.

When the Au plating is applied to the seal cover, Ni plating is performed first and the Au plating is generally applied thereon. In this case, the Ni plating thickness is preferably made 0.01 to 5 $\mu$m. Ni plating does not influence the flow of the brazing material, but for the above described purpose of the plating (securing corrosion resistance and wettability), the thickness of this extent is sufficient.

Concerning the brazing material which is fused, according to the study of the present inventors, the shape of the brazing material after being fused can be more easily made preferable by making the shape and size of the brazing material formed before being fused suitable. The brazing material which has the window frame shape and a shape index S obtained from the following formula of 2.5 to 6 inclusive is preferable.

## [Formula 1]

$$S = w/((a-2w) \cdot T)$$

In this formula, "w" represents a frame width (mm) of the brazing material, "a" represents a length of a long side of the brazing material, and T represents a thickness (mm) of the brazing material (see Fig. 2). The reason of specifying the size of the brazing material before being fused as described above is that if the shape index S is less than 2.5, the brazing material at the time of being fused stays in the corners to cause the poor shape, and if it exceeds 6, waste of the brazing material occurs.

The composition of the Au-Sn brazing material to be the brazing material is not especially limited, and the one with an Sn concentration of 10 weight% to 90 weight% can be applied. However, the preferable brazing material composition is that with an Sn concentration of 20 to 25 weight%, more preferably 20 to 22 weight% from the viewpoint of securing reliability at the time of sealing. The thickness of the brazing material is preferably made 10 to 40 $\mu$m in order to perform sealing reliably.

In manufacturing the seal cover according to the present invention, the manufacture process is the same as that of the conventional seal cover except for adjustment of the surface roughness of the surface of the seal cover main body, Au plating thickness, and the brazing material size. Specifically, the plate material formed from the material (Koval, 42 alloy) which constitutes the seal cover main body is formed, and Ni plating and Au plating are properly applied and then the brazing material is joined to the main body.

A preferable manufacture process as the manufacture process of the seal cover according to the present invention is that a plate material formed from Koval or a 42 alloy is rolled, on this occasion, the surface roughness is adjusted, and after this is worked to a desired size and shape as a seal cover by punching or the like, a brazing material is fused to it. The surface roughness by the rolling is adjustable by adjusting the surface roughness of the working surface of the pressing roll, and the surface roughness of the pressing roll working surface is adjustable by adjustment of the grinding conditions or the like.

When Ni plating and Au plating are applied to the seal cover main body, plating treatment is applied to the base material for which adjustment of the surface roughness and forming are performed as described above. At this time, the surface roughness of the surface after plating follows the surface roughness of the base material, and therefore, adjustment of the surface roughness does not have to be performed for the plated surface. The seal cover can be made by directly joining the brazing material to the seal cover main body after the plating treatment.

The brazing material is formed into the window frame shape by punching or the like before joined to the seal cover main body. Joining of the brazing material is preferably performed by fusion, and the conditions on this occasion are preferably the heating temperature of 310 to 350°C, and heating time of 0.1 to 10 minutes though it depends on the composition of the brazing material. As for fusion of the brazing material, in addition to the method for fusing the brazing material by placing the formed brazing material in a foil shape (solid state) to the seal cover main body, the brazing material in a paste form may be printed on the seal cover main body and fused to it.

As described thus far, in the hermetic seal cover according to the present invention, the flow of the brazing material when fused to the cover main body is controlled. As a result, the brazing material can be fused with its shape substantially kept, and the seal cover to which the brazing material in the window frame shape is fused can be efficiently produced.

Further, in the hermetic seal cover according to the present invention, the flow of the brazing material is improved, and therefore, the flow of the brazing material is favorable when it is joined to the base to seal it, and irregular flow of the brazing material can be suppressed. Accordingly, in addition to the shape of the brazing material being made favorable, inflow of the brazing material to the base which becomes the cause of the defect of the packages can be prevented. Since the flow of the brazing material is improved, there is no fear of occurrence of poor joint, or no need to use a large amount of brazing material. Use of the minimum required brazing material contributes to effective use of resources.

In the present invention, a preferable shape of the brazing material after fused is substantially a window frame shape, and the shape which satisfies 0.8w<W<1.6w with respect to the frame width "w" of the brazing material before fused when the frame width of the brazing material after fused is set as W. In the seal cover including such relation, the defect such as entry of the brazing material into the package or the like hardly occurs when it is joined to the base.

### Brief Description of the Drawings

Fig. 1 is a view schematically showing appearances of seal covers after brazing materials are fused; and
Fig. 2 is a view explaining the size of each portion of the brazing material.

### Best Mode for Carrying Out the Invention

Hereinafter, a preferred embodiment of the present invention is described. In this embodiment, the commercially available Koval plate material was worked with the surface roughness variously adjusted, and the Au-Sn brazing material was fused to this plate to form the seal covers. The shape of the brazing material and quality at the time of sealing the packages were evaluated.

The seal covers was produced as follows. The surface roughness was adjusted by rolling for the commercially available Koval plate material (size: 30 mm wide x 0.2 mm thick, surface roughness of 0.8 $\mu$m). In this embodiment, rolling was performed with the mill rolls adjusted in the working surface roughness under the respective conditions of #1000 grinding + lapping, #1000 grinding, #500 grinding, #180 grinding, and #80 grinding, and the plate materials with the surface roughness of 0.01 $\mu$m, 0.05 $\mu$m, 0.10 $\mu$m, 0.25 $\mu$m and 0.51 $\mu$m were made. From these plate materials, the base materials were worked by press-punching (size: 3.5 mm opening, 0.1 mm thick), Ni was plated to 2.18 $\mu$m and Au was plated to 0.01 to 0.1 $\mu$m by electrolytic barrel plating to form the seal cover main bodies.

Next, by fusing the Au-Sn brazing material in the window frame shape (outside dimension: 3.5 mm x 3.5 mm, inside dimension: 3.0 mm x 3.0 mm, frame width 0.25 mm) to the seal cover main bodies, the seal covers were produced. The shape index S in this case was 3.33. Fusing of the brazing material was performed by positioning and placing the brazing material on the seal cover main bodies, thereafter inserting them into the electric furnace, and heating them at 300 to 320°C for two minutes under the nitrogen atmosphere. As the fused brazing material, a plurality of Au-Sn brazing materials of the Sn concentrations of 20, 21 and 22 weight% were used. In this embodiment, 1000 seal covers were produced in accordance with each of the brazing material compositions and the like, and the yield and the like were evaluated.

With respect to the produced seal covers, the widths of the brazing materials after fused were measured first while the shapes of the brazing materials were confirmed, and the average width was obtained. Those with the widths of the brazing materials being 400 μm or less were determined as acceptable, and the yield of the acceptable products was calculated.

Next, by using the produced seal covers, they were joined to the bases, and which was evaluated. The bases used were made of alumina (size: 3.8 mm x 3.8 mm, height 2.0 mm). As a preliminary treatment, the top surfaces of the bases were metallized with tungsten, and further Ni plating of 3 μm and Au plating of 0.5 μm were made.

As for joining to the base, the seal covers were placed on the above described bases with the surfaces to which the brazing materials were fused down, and were sealed and joined by heating them at a temperature of 300 to 330˚C for three minutes under vacuum of $10^{-5}$ atm.

After sealing, first, the fillet widths (the widths of the brazing materials which lied off the seal covers when the packages were seen from above) were measured. Thereafter, the seal covers were removed from the bases, and presence or absence of the inflow of the brazing materials to the insides of the bases was checked. The presence or absence of the inflow was determined with the average value of the differences of the fused widths before and after sealing set as the entry average value. The above evaluation result is shown in Table 1.

[Table 1]

| No. | Cover main body surface roughness (μm) | Au plating (μm) | Brazing material composition | Cover evaluation | | Package evaluation | | Over-all evaluation |
|---|---|---|---|---|---|---|---|---|
| | | | | Fused width average (μm) | Yield (%) | Fillet width average (μm) | Brazing material entry average value (μm) | |
| 1 | 0.01 | 0.01 | AuSn20 | 261 | 99.5 | 138 | 20 or less | ◎ |
| 2 | | | AuSn21 | 277 | 98.5 | 139 | 20 or less | ◎ |
| 3 | | | AuSn22 | 265 | 98.7 | 145 | 20 or less | ◎ |
| 4 | | 0.05 | AuSn20 | 271 | 97.9 | 133 | 20 or less | ◎ |
| 5 | | | AuSn21 | 267 | 98.7 | 140 | 20 or less | ◎ |
| 6 | | | AuSn22 | 270 | 97.7 | 147 | 20 or less | ◎ |
| 7 | | 0.1 | AuSn20 | 295 | 83.5 | 128 | 53 | ○ |
| 8 | | | AuSn21 | 288 | 87.5 | 142 | 68 | ○ |
| 9 | | | AuSn22 | 330 | 85.2 | 145 | 49 | ○ |
| 10 | 0.05 | 0.01 | AuSn20 | 259 | 98.5 | 143 | 20 or less | ◎ |
| 11 | | | AuSn21 | 266 | 98.8 | 144 | 20 or less | ◎ |
| 12 | | | AuSn22 | 270 | 97.9 | 148 | 20 or less | ◎ |
| 13 | | 0.05 | AuSn20 | 261 | 97.5 | 140 | 20 or less | ◎ |
| 14 | | | AuSn21 | 259 | 98.6 | 141 | 20 or less | ◎ |
| 15 | | | AuSn22 | 270 | 97.9 | 148 | 20 or less | ◎ |
| 16 | | 0.1 | AuSn20 | 315 | 83.5 | 145 | 55 | ○ |
| 17 | | | AuSn21 | 298 | 85.5 | 147 | 71 | ○ |
| 18 | | | AuSn22 | 323 | 84.1 | 149 | 68 | ○ |

(continued)

| No. | Cover main body surface roughness (μm) | Au plating (μm) | Brazing material composition | Cover evaluation | | Package evaluation | | Over-all evaluation |
|---|---|---|---|---|---|---|---|---|
| | | | | Fused width average (μm) | Yield (%) | Fillet width average (μm) | Brazing material entry average value (μm) | |
| 19 | | | AuSn20 | 257 | 97.5 | 137 | 20 or less | ◎ |
| 20 | | 0.01 | AuSn21 | 274 | 96.8 | 141 | 20 or less | ◎ |
| 21 | | | AuSn22 | 270 | 98.5 | 143 | 20 or less | ◎ |
| 22 | | | AuSn20 | 265 | 98.5 | 136 | 20 or less | ◎ |
| 23 | 0.1 | 0.05 | AuSn21 | 258 | 98.7 | 142 | 20 or less | ◎ |
| 24 | | | AuSn22 | 261 | 97.9 | 143 | 20 or less | ◎ |
| 25 | | | AuSn20 | 331 | 82.4 | 138 | 74 | ○ |
| 26 | | 0.1 | AuSn21 | 325 | 85.7 | 141 | 56 | ○ |
| 27 | | | AuSn22 | 341 | 83.1 | 145 | 81 | ○ |
| 28 | | | AuSn20 | 291 | 90.5 | 142 | 45 | ○ |
| 29 | | 0.01 | AuSn21 | 286 | 88.3 | 135 | 58 | ○ |
| 30 | | | AuSn22 | 289 | 87.1 | 143 | 47 | ○ |
| 31 | | | AuSn20 | 288 | 88.5 | 136 | 41 | ○ |
| 32 | 0.25 | 0.05 | AuSn21 | 291 | 86.9 | 142 | 61 | ○ |
| 33 | | | AuSn22 | 295 | 87.4 | 143 | 58 | ○ |
| 34 | | | AuSn20 | 335 | 71.3 | 128 | 93 | Δ |
| 35 | | 0.1 | AuSn21 | 350 | 72.4 | 131 | 86 | Δ |
| 36 | | | AuSn22 | 338 | 68.6 | 135 | 88 | Δ |
| 37 | | | AuSn20 | 288 | 88.2 | 123 | 95 | Δ |
| 38 | | 0.01 | AuSn21 | 310 | 85.6 | 131 | 120 | Δ |
| 39 | | | AuSn22 | 325 | 87.2 | 133 | 143 | Δ |
| 40 | | | AuSn20 | 300 | 84.3 | 126 | 151 | Δ |
| 41 | 0.51 | 0.05 | AuSn21 | 275 | 88.1 | 132 | 141 | Δ |
| 42 | | | AuSn22 | 333 | 84.7 | 133 | 162 | Δ |
| 43 | | | AuSn20 | 351 | 48.1 | 128 | 250 | × |
| 44 | | 0.1 | AuSn21 | 341 | 47.3 | 131 | 221 | × |
| 45 | | | AuSn22 | 371 | 46.7 | 135 | 260 | × |

Yield: those with fused widths of 400 μm or less shall be acceptable Over-all judgment: judged from respective results of yield, fillet width and entry average value

Table 1 shows that by making the surface roughness of the seal cover main bodies 0.25 μm or less, those having favorable over-all judgment of the yield, fillet width and inflow of the brazing materials were obtained. It has been confirmed that especially by making the Au plating thickness 0.05 μm or less, in addition to the surface roughness, the yield becomes 95% or more, and the extremely excellent seal covers with less fear of entry of the brazing material can be obtained.

Meanwhile, the seal covers with the surface roughness of 0.51 μm which exceeds 0.25 μm significantly reduce

in yield though the average fused width was below 400 $\mu$m. This is because when the brazing materials are fused to the seal cover main bodies with such surface roughness, many brazing materials take indefinite shapes as in Fig. 1(a). About the evaluation when they were made packages, the fillet widths and entry average values were both abruptly degraded. When such inflow of the brazing material occurs at the time of sealing, there is the possibility that the brazing material reacts with the Ni plating of the seal cover, gas existing in the Ni plating is released, and has an adverse effect on the semiconductor element inside the package (for example, variation of the frequency of a crystal resonator occurs).

**Industrial Applicability**

According to the method according to the present invention, the hermetic seal cover to which a brazing material in a window frame shape is fused can be efficiently produced, and the hermetic seal cover according to the method of the present invention is improved in flow of the brazing material. Therefore, in addition to the shape of the brazing material being made favorable, inflow of the brazing material to the base which becomes the cause of the defect of the package can be prevented. There is no fear of causing poor joint or no need to use a large amount of brazing material. Use of the minimum required brazing material contributes to the effective use of resources.

**Claims**

1.   A method for manufacturing a hermetic seal cover in which a plate material formed from Kovar or a 42 alloy is formed to produce a seal cover main body, and an Au-Sn brazing material is fused to said seal cover main body, wherein before fusing said Au-Sn brazing material, surface roughness defined by JIS B0601 of said plate material is made to be 0.005 $\mu$m to 0.25 $\mu$m by rolling said plate material.

2.   The method for manufacturing the hermetic seal cover according to claim 1, wherein after the rolling, Ni plating and Au plating are performed.

3.   The method for manufacturing the hermetic seal cover according to claim 2, wherein a thickness of the Au plating is 0.003 $\mu$m to 0.05 $\mu$m.

4.   The method for manufacturing the hermetic seal cover according to claim 2 or claim 3, wherein a thickness of the Ni plating is 0.01 $\mu$m to 5 $\mu$m.

5.   The method for manufacturing the hermetic seal cover according to claims 2 to 4, wherein the Au-Sn brazing material which is fused to the seal cover main body has a window frame shape, and has a shape index S obtained from the following formula of 2.5 to 6 inclusive,

$$S = w/((a\text{-}2w)\cdot T)$$

where "w" represents a frame width (mm) of the brazing material, "a" represents a length of a long side of the brazing material, and T represents a thickness (mm) of the brazing material.

**Patentansprüche**

1.   Verfahren zur Herstellung einer hermetischen Dichtabdeckung, bei dem ein Plattenmaterial, das aus Kovar oder einer Legierung 42 gebildet ist, zu einem Dichtabdeckungshauptkörper ausgebildet ist und ein Au-Sn-Lötmaterial mit dem Dichtabdeckungshauptkörper schmelzverbunden ist, wobei vor dem Schmelzverbinden des Au-Sn-Lötmaterials durch Walzen des Plattenmaterials die Oberflächenrauheit, definiert durch JIS B0601, des Plattenmaterials auf 0,005 $\mu$m bis 0,25 $\mu$m eingestellt wird.

2.   Verfahren zur Herstellung der hermetischen Dichtabdeckung nach Anspruch 1, wobei nach dem Walzen eine Nikkelplattierung und Goldplattierung durchgeführt werden.

3.   Verfahren zur Herstellung der hermetischen Dichtabdeckung nach Anspruch 2, wobei eine Dicke der Goldplattierung 0,003 $\mu$m bis 0,05 $\mu$m beträgt.

**4.** Verfahren zur Herstellung der hermetischen Dichtabdeckung nach Anspruch 2 oder 3, wobei eine Dicke der Nikkelplattierung 0,01 $\mu$m bis 5 $\mu$m beträgt.

**5.** Verfahren zur Herstellung der hermetischen Dichtabdeckung nach Ansprüchen 2 bis 4, wobei das Au-Sn-Lötmaterial, das mit dem Dichtabdeckungshauptkörper schmelzverbunden ist, die Gestalt eines Fensterrahmens hat und einen Formindex S, der aus der folgenden Formel erhalten wird, von 2,5 bis einschließlich 6, aufweist:

$$S = w/((a \cdot 2w) \cdot T)$$

wobei "w" für eine Rahmenbreite (mm) des Lötmaterials, "a" für eine Länge einer langen Seite des Lötmaterials und "T" für eine Dicke (mm) des Lötmaterials stehen.

**Revendications**

**1.** Procédé pour fabriquer un couvercle de fermeture hermétique, dans lequel un matériau en plaque constitué de Kovar ou d'un alliage 42 est formé pour produire un corps principal de couvercle de fermeture, et un matériau de brasage en Au-Sn est fondu sur ledit corps principal de couvercle de fermeture, dans lequel, avant la fusion dudit matériau de brasage en Au-Sn, il est fait en sorte qu'une rugosité de surface définie par la norme JIS B0601 dudit matériau en plaque soit comprise entre 0,005 $\mu$m et 0,25 $\mu$m par un laminage dudit matériau en plaque.

**2.** Procédé pour fabriquer le couvercle de fermeture hermétique selon la revendication 1, dans lequel après le laminage, un placage de Ni et un placage d'Au sont réalisés.

**3.** Procédé pour fabriquer le couvercle de fermeture hermétique selon la revendication 2, dans lequel une épaisseur du placage d'Au est comprise entre 0,003 $\mu$m et 0,05 $\mu$m.

**4.** Procédé pour fabriquer le couvercle de fermeture hermétique selon la revendication 2 ou la revendication 3, dans lequel une épaisseur du placage de Ni est comprise entre 0,01 $\mu$m et 5 $\mu$m.

**5.** Procédé pour fabriquer le couvercle de fermeture hermétique selon les revendications 2 à 4, dans lequel le matériau de brasage en Au-Sn qui est fondu sur le corps principal de couvercle de fermeture présente la forme d'un cadre de fenêtre, et présente un indice de forme S compris entre 2,5 et 6 inclus et qui est obtenu à partir de la formule suivante:

$$S = w/((a-2w) \cdot T)$$

dans laquelle "w" représente une largeur de cadre (en mm) du matériau de brasage, "a" représente une longueur d'un côté long du matériau de brasage, et "T" représente l'épaisseur (en mm) du matériau de brasage.

## Fig. 1

( a )

Brazing material

( b )

Brazing material

## Fig. 2

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003224223 A
- US 4640438 A
- US 5639014 A